## Europäisches Patentamt

## European Patent Office

## Office européen des brevets

(11) Publication number: **0 171 274**
**B1**

## EUROPEAN PATENT SPECIFICATION

(45) Date of publication of patent specification: **02.01.91**

(21) Application number: **85305531.7**

(22) Date of filing: **02.08.85**

(51) Int. Cl.⁵: **H 01 L 31/024,**
**H 01 L 31/075, H 01 L 31/20**

(54) Photovoltaic device having long term energy conversion stability and method of producing same.

(30) Priority: **06.08.84 US 637984**

(43) Date of publication of application:
**12.02.86 Bulletin 86/07**

(45) Publication of the grant of the patent:
**02.01.91 Bulletin 91/01**

(84) Designated Contracting States:
**CH DE FR GB IT LI NL**

(56) References cited:
**EP-A-0 114 494**
**US-A-4 371 738**

**SOLAR CELLS, vol. 9, no. 1/2, June-July 1983, pages 25-36, Lausanne, CH; S. TSUDA et al.: "Light-induced instability of amorphous silicon photovoltaic cells"**

**SOLAR CELLS, vol. 9, no. 1/2, June-July 1983, pages 3-12, Elsevier Sequoia, NL; Y. UCHIDA et al.: "Stability of P-I-N hydrogenated amorphous silicon solar cells to light exposure"**

(73) Proprietor: **ENERGY CONVERSION DEVICES, INC.**
**1675 West Maple Road**
**Troy Michigan 48084 (US)**

(72) Inventor: **Guha, Subhendu**
**Maple Apartments 17 629 West Maple Road**
**Clawson Michigan 48017 (US)**
Inventor: **Denboer, William**
**756 Coachman Drive**
**Troy Michigan 48084 (US)**

(74) Representative: **Jackson, Peter Arthur et al**
**Gill Jennings & Every, 53-64 Chancery Lane**
**London WC2A 1HN (GB)**

(56) References cited:
**APPLIED PHYSICS LETTERS, vol. 43, no. 4, 15th August 1983, pages 368-370, American Institute of Physics, New York, US; T.D. MOUSTAKAS et al.: "Effect of boron compensation on the photovoltaic properties of amorphous silicon solar cells"**

Courier Press, Leamington Spa, England.

(56) References cited:

**JOURNAL OF APPLIED PHYSICS, vol. 55, no. 4, February 1984, pages 1168-1173, American Institute of Physics, New York, US; D.F. KENNEDY et al.: "Degradation and regeneration of amorphous silicon solar cells"**

**APPLIED PHYSICS LETTERS, vol. 44, no. 9, 1st May 1984, pages 916-918, American Institute of Physics, New York, US; M.C. OZTURK et al.: "Effects of annealing on the dark conductivity and photoconductivity of rf sputtered hydrogenated amorphous silicon"**

**Description**

Amorphous silicon alloys of electronic device quality can be prepared by glow discharge or vacuum deposition techniques. Such deposition techniques are described in US—A—4,226,898,'US—A—4,217,374, and US—A—4,517,223. As disclosed in those patents, fluorine introduced into the amorphous silicon semiconductor layers substantially reduces the density of the localized defect states and facilitates the addition of other alloying materials, such as germanium.

Unlike crystalline silicone which is limited to batch processing for the manufacture of solar cells, amorphous silicon alloys can be deposited in multiple layers over large-area subtrates to form solar cells in a high volume continuous processing system. Such continuous processing systems are disclosed in US—A—4,400,409, US—A—4,410,588, US—A—4,438,723 and US—A—4,485,125. As disclosed in those patents, a substrate may be continuously advanced through a succession of deposition chambers, in each of which a layer of semiconductor material is deposited. In making a photovoltaic device of p-i-n configuration, the first chamber is dedicated to depositing a p-type semiconductor alloy, the second chamber is dedicated to depositing an intrinsic amorphous semiconductor alloy, and the third chamber is dedicated to depositing an n-type semiconductor alloy.

The performance of amorphous silicon-based photovoltaic devices has been observed to degrade during operation. This process, termed "photo-degradation", or "Staebler-Wronski degradation" is believed to be caused by the breaking of weak bonds between atoms of the semiconductor material, resulting in the formation of defect states in the band gap. These photo-generated defects may be cured by annealing at elevated temperatures for a prolonged period of time, for example, a temperature of approximately 150°C for several hours.

In an operational photovoltaic module, annealing may be carried out periodically or continuously to restore or maintain performance. A continuous annealing solar collecting panel collects and retains solar thermal energy. The semiconductor material is maintained, during normal operation, at an elevated temperature (typically in excess of 100°C) and the defect states in the energy gap of the semiconductor material are annealed substantially simultaneously with their formation. However, the elevated temperatures required by the known continuous annealing process limits its use. It is therefore desirable to lower the annealing temperature.

According to the invention, a photoresponsive device formed of amorphous silicon or silicon-germanium comprises photoactive intrinsic layer of semiconductor material which includes a dopant selected from boron, aluminium, gallium, indium, thallium and combinations thereof in order to reduce the annealing temperature, at which light-induced defects are removed, to 100°C or less; and means for maintaining the device at the annealing temperature.

The invention also includes a method of fabricating an amorphous silicon or silicon-germanium semiconductor photoresponsive device wherein light-induced defects in a photoactive intrinsic layer adversely affect energy conversion efficiency, are removable by annealing at a temperature of 100°C or less, the method comprising incorporating in the intrinsic layer an amount of a p-dopant sufficient to move the Fermi level of the intrinsic layer to a position approximately 0.5 to 0.9 electron volts from the valence band thereof, the dopant being selected from boron, aluminium, gallium, indium, thallium and combinations thereof.

It has been reported that the addition of relatively small amounts of boron to the layer of intrinsic semiconductor material of a p-i-n photovoltaic device improves the stability of the device, but not that the dopant reduces the annealing temperature. See, "Light Induced Instability of Amorphous Silicon Photovoltaic Cells" by S. Tsuda, et al., 9 *Solar Cells*, 25—36 (1983) and "Stability of P-I-N Hydrogenated Amorphous Silicon Solar Cells to Light Exposure" Y. Uchida, et al., 9 *Solar Cells*, 3—12 (1983). The doping levels employed by Tsuda and Uchida are generally lower than those used in our invention. In contrast to our invention, any improvement in the stability or efficiency of photovoltaic devices produced in accordance with the Tsuda or Uchida publications is attributable to a change in the electric field distribution in the intrinsic region resulting from the addition of boron.

In one embodiment of the invention, the photovoltaic device is periodically raised to its annealing temperature by an electrical heater. In another embodiment, the photovoltaic device includes a thermally insulated module that retains solar thermal energy either to raise the semiconductor material to its annealing temperature periodically or to maintain the semiconductor material at its annealing temperature constantly.

In the accompanying drawings:

Figure 1 is a fragmentary, cross-sectional view of a stacked photovoltaic device comprising a plurality of p-i-n type cells, each layer of the cells formed from a disordered semiconductor alloy.

Figure 2 is a graph of photoconductivity data obtained under various conditions from a sample of semiconductor material fabricated in accordance with the invention, illustrating the improvement of the invention.

Figure 3 is a graph of photoconductivity data obtained under various conditions from a sample of semiconductor material fabricated in accordance with the invention, illustrating the improvement of the invention.

Figure 4 is a cross-sectional view of a photovoltaic module designed to attain and maintain an elevated temperature during at least a portion of the time of its operation and including a low temperature annealable photovoltaic material.

Figure 5 is a cross-sectional view of an electrically heated photovoltaic module designed to attain and maintain an elevated temperature during at least a portion of the time of its operation and including a low temperature annealable photovoltaic material.

Figure 6 is a cross-sectional view of an electrically heated photovoltaic cell.

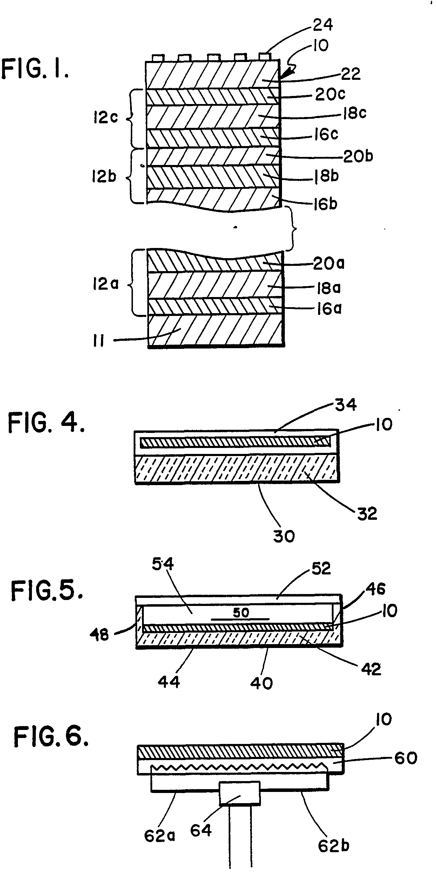

Figure 1 shows a p-i-n type photovoltaic device 10 made up of individual p-i-n type cells 12a, 12b, and 12c. A substrate 11 joins cell 12a and functions as an electrode of cell 10. Substrate 11 may be formed of a metallic material such as thin stainless steel or aluminum, or it may be formed from a thin electroformed member such as nickel. Alternatively, substrate 11 may be formed from an insulating material such as glass or synthetic polymers, with an electrically conductive electrode layer formed on it. Although certain applications may require the deposition of a thin oxide layer and/or a series of base contacts and/or a reflecting layer upon the substrate prior to the deposition of the semiconductor material, the term, "substrate" as used here includes any such elements added by preliminary processing.

Each of the cells, 12a, 12b, and 12c are fabricated from an amorphous semiconducotr body containing at least silicon or germanium. Each of the semiconductor bodies includes an n-type conductivity semiconductor layer 20a, 20b, and 20c; a lightly doped intrinsic semiconductor layer 18a, 18b and 18c, in accord with the principles of the instant invention; and a p-type conductivity semiconductor layer 16a, 16b, and 16c. P-type layers 16 and n-type layers 20 cooperate to establish an electric field across intrinsic layers 18 for collection of charge carriers generated in layers 18 by light.

A TCO (transparent conductive oxide) layer 22, formed in the preferred embodiment of indium tin oxide, is deposited on the layer of semiconductor material opposite substrate 11 and forms a second electrode. An electrode grid 24 may be applied to TCO layer 22 to increase current collection efficiency.

While the photovoltaic cell illustrated in Figure 1 is a stacked assembly of p-i-n cells, the invention may also be employed with other cell arrangements such as single p-i-n cells, or stacked or single n-i-p or p-n cells.

Applicants have shown analytically and confirmed experimentally that the incorporation of small amounts of selected annealing temperature reducing agents, such as, for example, p-dopants, into a host matrix of an intrinsic amorphous semiconductor results in a reduction in the temperature at which light-induced defects may be removed by annealing. The reduction in temperature annealing is independent of any particular device configuration in which the amorphous semiconductor may be used. Therefore, the improved amorphous semiconductor of the invention may be incorporated in a wide variety of photoresponsive devices, such as the tandem p-i-n type photovoltaic device described with reference to Figure 1.

The improved amorphous semiconductor may be deposited by sputtering, in which case the annealing temperature reducing agent may be either present in solid form in the sputtering target, or introduced into the atmosphere in the deposition chamber in gaseous form. If introduced in an evaporation process, the annealing temperature reducing agent is either added to the solid being evaporated or added to the residual atmosphere in the deposition chamber. If chemical vapor deposition is employed for the fabrication of the amorphous semiconductor, the annealing temperature reducing agent is preferably added to the process gas stream. In an electroplating process, an appropriate amount of annealing temperature reducing agent is either added to the electrode from which the plated deposit is formed or is added directly to the plating bath. In a glow discharge process, the annealing temperature reducing agent is added to the process gas stream.

Previously deposited layers of amorphous semiconductors may have an annealing temperature reducing agent introduced into them by ion implantation, post deposition treatment in an activated atmosphere of the annealing temperature reducing agent or a diffusion process.

The invention is further explained with reference to the preparation of an intrinsic amorphous silicon:hydrogen alloy. This intrinsic alloy is generally similar to that utilized in intrinsic layers, 18a, 18b and 18c of photovoltaic device 10 of Figure 1. A series of layers of an amorphous silicon:hydrogen alloy were deposited by a glow discharge process on Corning 7059 glass substrates maintained at 250°C. Silane was decomposed using radio frequency energy of 13.56 MHz. The decomposition was carried out at a pressure of approximately 27 pascal. Samples of a layer of an amorphous silicon:hydrogen alloy incorporating various levels of boron were prepared by adding differing small amounts of diborane to the chamber as the non-doped alloys were being deposited.

Each of the samples was annealed at 200°C for two hours to remove any defects created during preparation of the samples. The annealed samples were then degraded by exposure to a white light flux of approximately 100 mW/cm² for 2 hours. Photoconductivity of the degraded samples was then measured, the samples were next annealed at 100°C for 15 minutes and the photoconductivity measured again.

The samples have a band gap of approximately 1.8 eV with the Fermi level located approximately 1.1 eV from the valence band (i.e., 0.7 eV from the conduction band), and therefore, are regarded as slightly n-type. In conventional intrinsic amorphous silicon, annealing at 100°C for 15 minutes has virtually no effect upon light-induced defects. Applicants have found that the incorporation of a p-dopant, particularly boron, in amounts sufficient to shift the Fermi level of the intrinsic amorphous semiconductor alloy toward the valence band (thereby making the intrinsic semiconductor slight p-type) results in an improvement in the

4

annealing characteristics. More specifically, for an amorphous silicon:hydrogen alloy that incorporates boron as the annealing temperature reducing agent, it was found that the Fermi level was shifted to a new position approximately 0.7 eV from the valence band to produce an amorphous semiconductor from which light-induced defects may be annealed by a temperature of only approximately' 100°C for only approximately 15 minutes.

Measured data appears in Table I. In the first column, the amount of diborane gas relative to the amount of silane gas present in the process gas stream is given in parts per million. The second column indicates the activation energy, in electron volts (eV), for each sample, and provides a precise basis for comparing the relative amounts of boron incorporated into the samples. Samples 1, 2 and 3 are slightly p-type, while sample 4 is very slightly n-type. The third column lists the ratio of the photoconductivity of the photo-degraded silicon semiconductor ($\text{sigma}_{phB}$) to the photoconductivity of the reference silicon alloy semiconductor ($\text{sigma}_{phA}$) which was annealed at 200°C. Finally, the fourth column lists the ratio of the photoconductivity of the photo-degraded, and subsequently low-temperature annealed sample of amorphous silicon ($\text{sigma}_{phC}$) to the photoconductivity of the reference annealed sample ($\text{sigma}_{phA}$). Column 3 is thus a measure of the degree of photo-degradation occurring in the sample after light soaking (exposure to illumination of AMI intensity) and column 4 represents a measure of the recovery of that sample after the annealing at 100°C for 15 minutes. The larger the number in column 3, the lower the degree of photo-degradation of the sample, and the large the number in column 4, the greater the recovery of the sample after annealing.

TABLE I

| Sample α | $B_2H_6/SiH_4$ (ppm) | $E_{a(ev)}$ | $\text{sigma}_{phB}/ \text{sigma}_{phA}$ | $\text{sigma}_{phC}/ \text{sigma}_{phA}$ |
|---|---|---|---|---|
| 1 | 67 | .77 | .10 | .9 |
| 2 | 200 | .70 | .67 | 1.0 |
| 3 | 600 | .64 | .79 | 1.0 |
| 4 | 10 | 1.08 | .10 | .24 |

The photoconductivity data of Table 1 was measured parallel to the layer of silicon using colloidal graphite electrical contacts spaced approximately 2 mm apart. A constant voltage of approximately 100 volts was applied to the sample, and the flow of current was measured as a function of the intensity of illumination.

The data in Table I show that low temperature annealing restores the slightly p-doped, photodegraded samples (samples 1, 2 and 3) to essentially their initial performance. Sample 4, which includes only very small amounts of boron and is slightly n-type, recovers only 24Δ of the predegradation photoconductivity following the brief, low temperature annealing process that substantially restored samples 1—3.

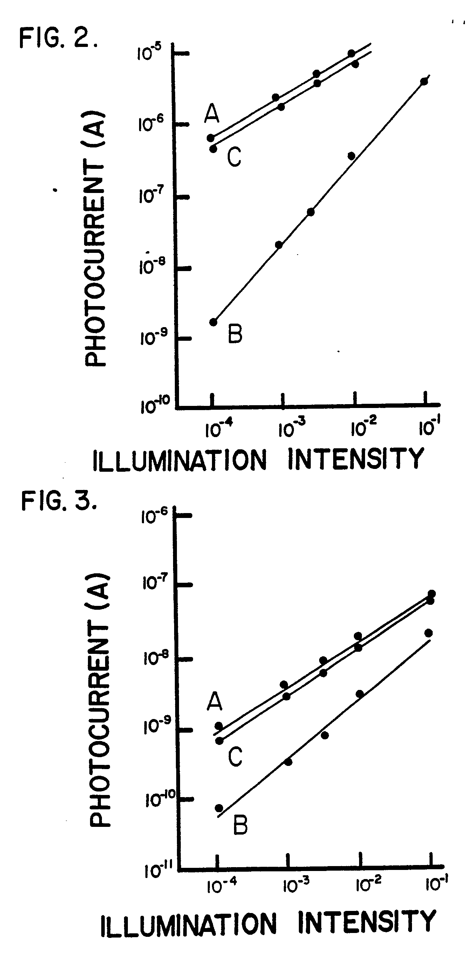

Figure 3 is a graph of the photoconductivity data taken from sample 1 of Table I and illustrates the recovery of amorphous semiconductor including the low temperature annealing ingredient according to the invention. Line A depicts the electrical performance of sample 1 following a high temperature annealing process (2 hours at 200°C), that is, the reference performance line for the sample. Line B is the photoconductivity of the amorphous silicon after photo-degradation (white light illumination of 100 mW/cm² for 2 hours). Line C is the photoconductivity of the same sample following a 15 minute annealing treatment at 100°C. Figure 3 shows that a brief low-temperature annealing process restores the novel amorphous silicon to approximately its reference performance.

Figure 2 is a graph similar to Figure 3 for the same sample, except that the photoconductivity was measured in a direction perpendicular to the plane of the deposited layer of amorphous silicon. In the sample, a 50 nanometer thick layer of p⁺-type, i.e. heavily p doped, amorphous silicon was deposited on a chromium coated Corning 7059 glass substrate, followed by the deposition of 1.5 microns of the silicon alloy being evaluated and another 50 nanometer thick p⁺-type layer. Ohmic contacts were made to the chromium layer and the opposed p⁺-type layer. A constant voltage of approximately 0.2 volts was applied and photoconductivity measured to demonstrate that the improved annealing characteristics represent anisotropic material properties and do not depend upon any particular device configuration. Figure 3 shows that the electrical performance of the sample, as measured parallel to the layer is generally similar to the electrical performance measured through the layer shown in Figure 2. The overall photocurrent passed through the sample is lower in Figure 3 than in Figure 2, because of a longer the current path, but the magnitude of the changes in photocurrent on degradation and annealing is similar. Therefore, a photovoltaic device fabricated in accordance with the invention needs to be annealed only once or twice a year at a temperature of approximately 100°C for a period of time as short as 15 minutes to eliminate photo-induced defects.

Photovoltaic devices according to the invention may be incorporated into modules specifically designed to attain and maintain elevated temperatures during operation. These annealing operations may be performed on a periodic basis, i.e., occasional hot sunny days may be relied upon to raise the semiconductor material of a photovoltaic device to the annealing temperature for a period of time sufficient to remove defects that have accumulated during the previous operation of said device. Alternatively, a continuous annealing process may be employed. In a continuous annealing process, the semiconductor material is constantly maintained at a somewhat lower annealing temperature during a significant portion of its operation.

In Figure 4, a module 30 includes a photovoltaic device 10 that may be similar to device 10 of Figure 1. A base or backing member 32 underlies photovoltaic device 10 and an encapsulant 34 forms a substantially air-tight seal between device 10 and backing member 32. Backing member 32 is formed from a thermally insulating material having a thermal conductivity of less than $10^{-3}$ W/cm°C such as, for example, glass wool, styrofoam, cork, etc.

Encapsulant 34 is preferably formed from a transparent, polymeric material such as Tedlar (registered trademark of E. I. Dupont de Nemours, Inc.) and totally encapsulates device 10 to protect it and prevent heat loss. In operation, photovoltaic device 10 absorbs light energy to produce electrical energy and heat. The heat cannot be conducted away because of thermal insulation provided by backing member 32 and encapsulant 34. As a result, device 10 attains and maintains an elevated temperature causing low temperature annealing.

In Figure 5 a module 40 includes a photovoltaic device 10 and an enclosure 42 having a bottom wall 44, four side walls, only three of which are illustrated, and a transparent cover 52. Enclosure 42 is either formed from, or contains, a thermal insulating material such as glass wool, styrofoam, cork, etc. and is dimensioned to receive and retain device 10 in contact with bottom wall 44. The side walls of enclosure 42 extend from bottom wall 44 and form an air space 54 between the front surface of device 10 and cover 52. Cover 52 bridges the side walls of enclosure 40 to encapsulate device 10. Cover 52 can be formed from glass or other similar rigid or semirigid transparent material and may be affixed to the side walls by an adhesive, such as an epoxy adhesive.

Incident light passes through cover 52 and strikes device 10 which absorbs the light and produces electricity and heat. The heat produced is prevented from escaping by backing member 32 and air space 54. In this manner, device 10 is maintained at a sufficiently elevated operating temperature to achieve low temperature annealing.

Operating temperatures sufficient to anneal defects from a photovoltaic device according to the invention may be attained by enclosing the entire photovoltaic device in a relatively thick layer of encapsulant material having a high degree of optical transparency and relatively low thermal conductivity. Among such materials are various silicones, synthetic organic resins, inorganic glasses, and the like.

It may be desirable in some cases to use electrical heating to perform the annealing operation. In Figure 6, an electrical resistance heater 60 is attached to the rear surface of a photovoltaic cell 10 to anneal the cell. The cell may be similar to cell 10 of Figure 1. An appropriate thin, sheet-like heater is a Thermofoil brand heater manufactured by Minco Products, Inc. of Minneapolis, Minnesota, U.S.A. Alternatively, a resistance heating element may be deposited directly upon the back surface of the substrate of cell 10 by screen printing or vacuum deposition. Electrical heater 60 includes a pair of electrical leads 62a and 62b and, preferably, a controller 64 to regulate the intensity, duration and frequency of application of heat to cell 10.

Continuous annealing may also be achieved in a resistively heated photovoltaic device. Electrical energy may be constantly trickled to a heater so as to maintain the photovoltaic device at its annealing temperature continuously. Where ambient temperature and/or wind-chill conditions make it difficult to attain and maintain the desired annealing temperature in a passively heated module, a small resistance heater may be employed to provide sufficient additional warmth to anneal the semiconductor material. Although the detailed discussion of the invention referred primarily to photovoltaic devices, the invention may also be applied to other types of photoresponsive devices such as phototransistors, photodiodes, photodetectors, or any other photoresponsive semiconductor device, that is prone to form defects in response to the absorption of photons.

**Claims**

1. A photoresponsive device (10) formed of amorphous silicon or silicon-germanium comprising a photoactive intrinsic layer (18) of semiconductor material which includes a dopant selected from boron, aluminium, gallium, indium, thallium and combinations thereof in order to reduce the annealing temperature, at which light-induced defects are removed, to 100°C or less; and means for maintaining the device at the annealing temperature.

2. A device according to claim 1, in which the means for maintaining is an electric heater (60).

3. A device according to claim 1, wherein the means for maintaining includes an enclosure (30) housing the semiconductor material, the enclosure (30) being at least partially transparent to solar radiation and thermally insulated to prevent loss of heat from the interior of the enclosure (30).

4. A device according to any one of the preceding claims, wherein the intrinsic layer (18) is between and in electrical contact with, a layer (16) of p-type semiconductor material and a layer (20) of n-type semiconductor material.

5. A device according to any one of the preceding claims, wherein the dopant is présent in the intrinsic layer in an amount sufficient to move the Fermi level of the intrinsic semiconductor layer (18) to within 0.5 to 0.9 electron volts from the valence band of the semiconductor.

6. A method of fabricating an amorphous silicon or silicon-germanium semiconductor photoresponsive device (10) wherein light-induced defects in a photoactive intrinsic layer (18) which adversely affect energy conversion efficiency, are removable by annealing at a temperature of 100°C or less, the method comprising incorporating in the intrinsic layer an amount of a p-dopant sufficient to move the Fermi level of the intrinsic layer to a position approximately 0.5 to 0.9 electron volts from the valence band thereof, the dopant being selected from boron, aluminium, gallium, indium, thallium and combinations thereof.

7. A method according to claim 6, wherein the device includes a layer (16) of p-type semiconductor material disposed in electrical contact with the intrinsic layer (18) and a layer (20) of n-type semiconductor material disposed in electrical contact with the intrinsic layer and opposite to the p-type layer.

**Patentansprüche**

1. Fotoempfindliche Anordnung (10) gebildet aus amorphem Silizium oder Silizium/Germanium bestehend aus einer fotoaktiven eigenleitenden Schicht (18) aus Halbleitermaterial, die einen Dotierstoff enthält, der ausgewählt wurde aus Bor, Aluminum, Gallium, Indium, Thallium und Kombinationen daraus, um die Vergütungstemperatur, bei der lichtinduzierte Fehler entfernt werden, auf 100°C oder weniger herabzusetzen und aus Mitteln zum Behandeln der Anordnung (10) bei der Vergütungstemperatur.

2. Fotoempfindliche Anordnung nach Anspruch 1, bei der das Behandlungsmittel eine elektrische Beheizung (60) ist.

3. Fotoempfindliche Anordnung nach Anspruch 1, wobei das Behandlungsmittel eine Einfassung (30) zum Einschluß das Halbleitermaterials umfaßt, wobei die Einfassung mindestens teilweise durchlässig für die Sonnenstrahlung und thermisch gekapselt ist, um Wärmeverluste aus dem Innern der Einfassung (30) zu verhindern.

4. Fotoempfindliche Anordnung nach einem der vorstehenden Ansprüche, wobei die eigenleitende Schicht (18) zwischen und in elektrischem Kontakt mit einer Schicht (16) aus p-Typ Halbleitermaterial und einer Schicht (20) aus n-Typ Halbleitermaterial angeordnet ist.

5. Fotoempfindliche Anordnung nach einem der vorhergehenden Ansprüche, wobei der Dotierungsstoff in der eigenleitenden Schicht (18) in einer solch hinreichenden Menge vorhanden ist, daß das Ferminiveau der eigenleitenden Halbleiterschicht (18) auf einen Abstand zwischen 0,5 bis 0,9 Elektronenvolt vom Valenzband des Halbleiters bewegbar ist.

6. Verfahren zur Herstellung einer fotoempfindlichen Anordnung (10) aus einem amorphen Silizium-/ oder Silizium/Germaniumhalbleiter, wobei lichtinduzierte Fehler in der fotoaktiven eigenleitenden Schicht (18), welche den Wirkungsgrad für die Energieumwandlung ungünstig beeinflussen, durch Vergütung bei einer Temperatur von 100°C oder weniger entfernbar sind, woei das Verfahren darin besteht, in die eigenleitende Schicht eine Menge von einem p-Dotierungsmittel einzubringen, die ausreicht, um das Ferminiveau der eigenleitenden Schicht in eine Lage von 0,5 bis 0,9 Elektronenvolt von dessen Valenzband zu bewegen, wobei das Dotierungsmittel aus Bor, Aluminium, Gallium, Indium, Thallium und Kombinationen daraus ausgewählt wird.

7. Verfahren nach Anspruch 6, wobei die fotoempfindliche Anordnung eine Schicht aus p-Typ Halbleitermaterial enthält, die in elektrischem Kontakt mit der eigenleitenden Schicht (18) und einer Schicht (20) aus n-Typ Halberleitermaterial steht, welche in elektrischem Kontakt mit der eigenleitenden Schicht steht, und gegenüber der p-leitenden Schicht angeordnet ist.

**Revendications**

1. Dispositif photosensible (10), formé de silicium, ou de silicium-germanium, amorphe, comprenant, d'une part, une couche intrinsèque photo-active (18) de matériau semi-conducteur qui contient un agent de dopage, choisi parmi le bore, l'aluminium, le gallium, l'indium, le thallium et des combinaisons de ceux-ci, pour abaisser à 100°C ou moins la température de recuit à laquelle les défauts provoqués par la lumière sont éliminés, et, d'autre part, des moyens de maintien du dispositif à cette température de recuit.

2. Dispositif selon la revendication 1, dans lequel les moyens de maintien sont constitués par un dispositif de chauffage électrique (60).

3. Dispositif selon la revendication 1, dans lequel les moyens de maintien sont constitués par une enceinte (30) dans laquelle est logé le matériau semi-conducteur, cette enceinte (30) étant au moins partiellement transparente au rayonnement solaire et étant isolée thermiquement afin d'empêcher une perte de chaleur à partir de l'intérieur de cette enceinte (30).

4. Dispositif selon l'une quelconque des revendications précédentes, dans lequel la couche intrinsèque (18) est située, en étant en contact électrique avec elles, entre une couche (16) d'une matériau semi-conducteur de type p et une couche (20) de matériau semi-conducteur de type n.

5. Dispositif selon l'une quelconque des revendications précédentes, dans lequel l'agent de dopage est présent dans la couche intrinsèque en une quantité suffisante pour déplacer le niveau de Fermi de cette couche semi-conductrice intrinsèque (18) jusqu'à une valeur s'écartant de 0,5 à 0,9 électron-volt de la bande interdite du semi-conducteur.

6. Procédé de réalisation d'un dispositif photosensible (10) à semi-conducteur formé de silicium, ou de silicium-germanium, amorphe, dans lequel les défauts provoqués par la lumière dans une couche intrinsèque photo-active (18) et ayant une influence négative sur l'efficacité de la transformation d'énergie peuvent être éliminés à l'aide d'un recuit à une température de 100°C ou moins, ce procédé consistant à introduire dans la couche intrinsèque une quantité d'un agent de dopage de type p qui est suffisante pour déplacer le niveau de Fermi de cette couche intrinsèque jusqu'en une position située approximativement de 0,5 à 0,9 électron-volt de la bande interdite de cette couche, cet agent de dopage étant choisi parmi le bore, l'aluminium, le gallium, l'indium, le thallium et des combinaisons de ceux-ci.

7. Procédé selon la revendication 6, selon lequel le dispositif comprend une couche (16) de matériau semi-conducteur de type p, disposée en contact électrique avec la couche intrinsèque (18), et une couche (20) de matériau semi-conducteur de type n, disposée en contact électrique avec la couche intrinsèque et à l'opposé de la couche de type p.

FIG. 1.

FIG. 4.

FIG.5.

FIG.6.

FIG. 2.

FIG. 3.